# EUROPEAN PATENT SPECIFICATION

(11) **EP 1 092 109 B1**
(45) Date of publication and mention of the grant of the patent: **15.05.2002**
(21) Application number: 99934528.3
(22) Date of filing: 28.06.1999
(51) Int. Cl.: F16L 21/06, F16L 23/08, F16L 37/08, C23C 14/34, H01J 37/34

(54) **VACUUM TIGHT COUPLING FOR TUBE SECTIONS**
VAKUUMDICHTE KUPPLUNG FÜR ROHRE
DISPOSITIF DE COUPLAGE ETANCHE POUR SECTIONS DE TUYAUX

(30) Priority: 29.06.1998 EP 98202183
(43) Date of publication of application: 18.04.2001
(73) Proprietor: SINVACO N.V., 9870 Zulte (BE)
(72) Inventor: CNOCKAERT, Dirk, B-9800 Deinze (BE); DE BOSSCHER, Wilmert, B-9031 Drongen (BE); LOOTENS, Erwin, B-9031 Drongen (BE); VERHEYEN, Pascal, B-9890 Gavere (BE)
(74) Representative: Bird, Ariane
(86) International application number: EP9904085
(87) International publication number: WO0000766

(56) References cited:
- WO-A-92/02659
- WO-A-94/16118
- US-A- 5 467 612
- US-A- 5 480 193
- US-A- 5 527 439
- US-A- 5 591 314

## Description

The invention relates to a vacuum tight coupling for the end portions of two tubular sections. In particular it relates to the coupling of heavy tube sections which have to rotate around their longitudinal tube axis such as, for example, rotatable targets in vacuum sputtering reactors, in particular magnetrons.

### Background of the invention

Vacuum or at least fluid tight couplings for tube ends are known from the patent publications DE 3328137; US 4,900,063; US 5,591,314; WO 85/04940 and EP 0726 417. Most of these coupling devices include clamping rings that, due to the nature of their fixing means, do not have a substantially cylindrical outer surface. This prevents tube rotation within a small opening surrounding -i.e. radially facing - the clamping rings. In addition, when joined, the transverse tube extremities essentially abut with their end faces against each other with sealing means positioned in between them in this transverse abutment area. When one tube end has to carry the other heavy tube, e.g. in cantilever mode and optionally has to set it in rotation, e.g. at a considerable speed, then the structure of these known abutment-type couplings is subjected to virtually insupportable stresses and loads.

US 5,480,193 describes a push-on fitting including a split clamp. An inner tube end is provided with two "0" ring seals and an outer tube end is pushed over the seals. Each half of the axial clamp includes a semi-annular surface positioned to encircle that portion of the push-on fitting lying over the seals. Elastic inserts are placed in the clamp which clamp down onto the outer tube. Due to the use of elastic components there is some possibility of relative movement between the inner and outer tube.

US 5,647,612 describes a push-on tube fitting which is clamped by a hinged clamp. In the closed position the two halves of the clamp co-operate to form a recess corresponding to that of the fitted part of the couplings, thereby axially restraining the couplings but not clamping them together. The clamp is held closed by a releasable locking mechanism.

### Object and summary of the invention

It is an object of the invention to avoid the disadvantages of known couplings and to provide a reliable vacuum tight coupling for relatively heavy tube sections. It is also an object to design such a coupling which permits rotation at relatively high speeds when needed. It is a further object to produce a coupling which can easily be assembled and disassembled and which is readily usable e.g. as a spindle/target-coupling for a rotatable sputtering target. The coupling is designed for multiple disassembly and reassembly. After fixing the coupling, the spindle may be attached to its supporting unit, e.g. an end block which is provided with the connections for driving and cooling the inner space of the target tube.

In the vacuum tight coupling according to claim 1 for the end portions of two tubular sections according to the present invention the inner diameter of the first end portion is chosen to be smaller than that of the second end portion. This second end portion carries a radially outwardly extending flange extremity and this portion can be slid axially over the first end portion to abut against a peripheral outer abutment ring on said first end portion. At least one sealing ring is provided between said end portions in their overlapping cylindrical contact area. The coupling comprises further a clamping ring with a substantially cylindrical outer surface. This ring is composed of two substantially equal halves with each a U-shaped cross section with an inwardly oriented recess, said recess enclosing said flange portion of the second end portion and said abutment ring of the first end portion. Tightening of the clamp results in longitudinal (axial) positive and solid clamping of the abutment ring to the flange. The clamp operates directly on the flange and ring. Preferably, the load bearing surfaces of the clamp, flange extremity and abutment ring are made of metal, e.g. steel. The fixing means for the ring halves comprise in at least one place bolting means, the axis of which is perpendicular to the longitudinal axis of the coupled tubular sections and substantially tangential to the clamping ring periphery.

To provide for a robust coupling, said overlapping cylindrical contact area, where one tube end enters the other, should exceed a minimum surface in relation to the inner diameter "d" of the first end portion. For example, the minimum overlap may be 5% of the inner diameter of the first end portion. In this manner the entering tube end will offer a proper mechanical support for the surrounding tube end during any conditions of operation. To allow ease of coupling in confined spaces the amount of overlap should preferably be limited in length. For example, it is preferred if the length of overlap between the first and second end portions is 50% or less of the inner diameter "d" of first end portion. more preferably 30% or less and most preferably 20% or less. The overlap may be 10%. This amount of overlap is sufficient to provide both enough space for sealing rings and also mechanical stability.

To prevent arcing is it preferable to attach an anti-arcing element to the surface of the clamping ring. The anti-arcing element may be a ring. The anti-arcing element may be made of an insulating or a conductive material.

The invention will now be described with reference to the attached drawings. Further details and advantages will be clarified, in particular in relation to certain preferred embodiments for couplings for spindles to rotatable targets.

### Brief description of the drawings

Fig. 1 is a longitudinal cross sectional view of a coupling according to an embodiment of the present invention.
Fig. 2 is a transverse cross section of Fig. 1 showing clamping ring halves.
Fig. 3 is a longitudinal cross sectional view of an alternative embodiment wherein, i.a. the flange extremity on the second end portion is a separate ring.
Fig. 4 shows a transverse cross section of the clamp of Fig. 3.
Fig. 5 shows in longitudinal cross section an alternative embodiment of the fixing arrangement for the two halves of the clamping ring.
Fig. 6 shows a transverse cross-section of the clamp of Fig. 5.
Fig. 7 relates to the insertion of a tubular section between first and second end portions of the two couplings.
Fig. 8 is an exploded schematic view of a coupling according to a further embodiment of the present invention.
Fig. 9 is a longitudinal cross-sectional detail of the coupling of Fig. 8.

### Detailed description of certain embodiments

The present invention will be described with reference to certain embodiments and to certain drawings but the present invention is not limited thereto but only by the claims. The coupling in accordance with the present invention is particularly suitable as a vacuum coupling. The couplings in accordance with the present invention are not only suitable for levels of vacuum in the range 0.5 to 0.01 bar but are also suitable for high vacuum levels such as 10⁻³ or lower, in particular 10⁻⁵ or lower, for example 10⁻⁶ to 10⁻⁹ bar. Couplings in accordance with the present invention may be ultra-high vacuum couplings. Ultra-high vacuum in accordance with this invention is 10⁻ ¹⁰ bar or lower, e.g. 10⁻¹¹ down to 10⁻¹⁵ bar.

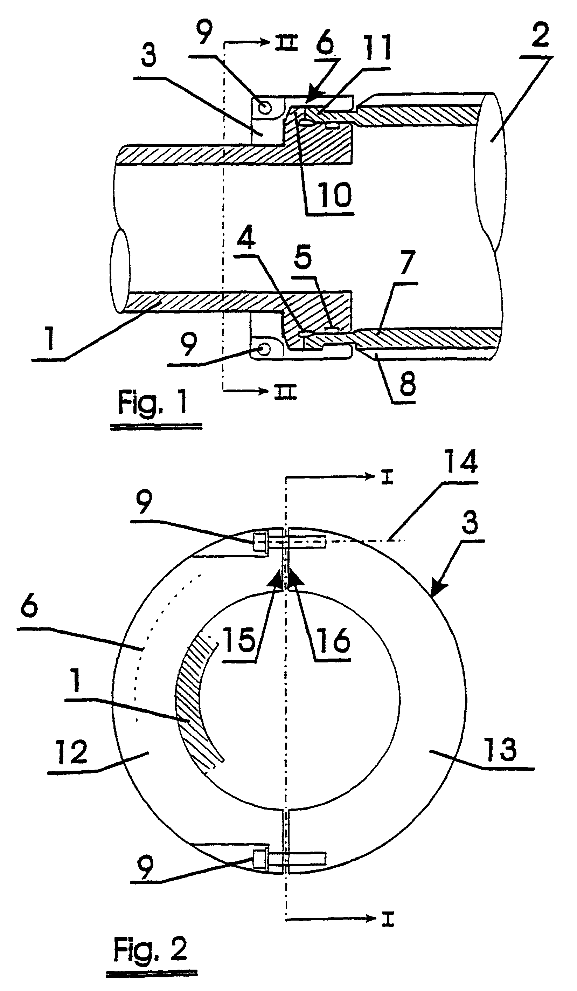

An embodiment of a vacuum tight coupling in accordance with the present invention is shown schematically in Fig. 1. Generally, the structural materials of the coupling may be made of a metal, e.g. steel, or any other suitable high strength material. The coupling has end portions 1, 2 of two tubular sections. The first end portion 1 may have a smaller inner diameter than that of end portion 2. When applying the invention to a spindle/target-coupling, the first end portion 1 is part of, or fits into or onto the spindle and the second end portion 2 is part of the target tube or fits into or onto the target tube. The target tube may have an inner support tube 7 onto which the cylindrical layer 8 of target material is fixed. The size of the inner space of the first end portion 1 is smaller than that of the second end portion 2. The second end portion 2 carries a flange extremity 11 which can be slid axially over the first end portion 1 to come to rest abutted against a peripheral outer abutment ring 10 on said first end portion. The contact between the abutment ring 10 and the flange 11 will be called the abutment area.

The coupling includes at least one sealing ring 4, 5 between said end portions in their overlapping contact area. Sealing ring 4, 5 may be an O-ring seal. An O-ring 5 is preferably arranged in a circumferential groove on the outside of the end portion of the spindle. An O-ring 4 is preferably located near the abutment area with the end portion of the target tube. Although one O-ring could in principle assure a vacuum tight sealing, two 0-rings warrant a maximal vacuum integrity under the most extreme conditions of operation.

Both 0-rings 4 and 5 are mounted on the spindle during assembly. This arrangement provides an automatic and uniform pressure on the seal which minimises the risk of damaging them or the sealing surfaces during assembly, revision, cleaning and target exchange. The couplings in accordance with the present invention are designed for repetitive assembly and disassembly while still maintaining their mechanical properties, e.g. suitable for vacuum or ultra-high vacuum conditions. Rubber O-ring seals (e.g. Viton™ rubber O-rings) are suitable for high vacuum use, i.e. down to about 10⁻⁹ bar. Due to outgassing from the rubber such rings are not preferred for ultra-high vacuum use. Toroidal flexible metal seals supplied under the trade name Helicoflex™ (supplier Le Carbone-Lorraine, France) may be used instead of rubber O-rings for ultra-high vacuums, e.g. 10⁻¹¹ to 10⁻¹⁵ bar.

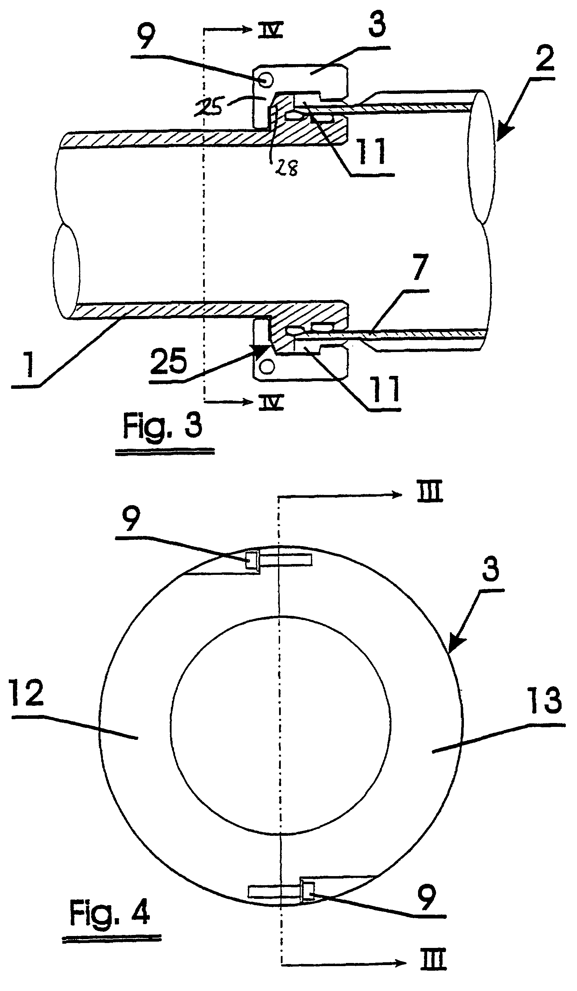

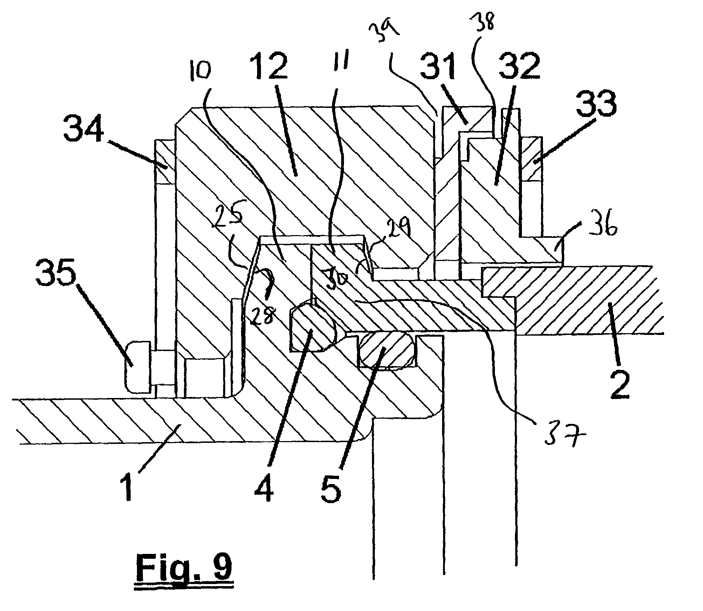

The coupling comprises further a clamping ring 3 with a substantially cylindrical outer surface. Substantially cylindrical means that the envelope of the outer circumference of the ring with its fixing means 9 does not show parts which extend radially outside said circumference to a significant extent. As a result, cylindrical shields may be placed quite closely over the clamp without touching it, even during relative rotation between the clamp and the cylindrical shield. Clamping ring 3 is preferably made from a high strength material such as a metal, e.g. steel. The clamping ring 3 is composed of two substantially equal halves 12,13, each having a semi-circular or U-shaped cross section with an inwardly oriented recess 6. Upon closing the ring 3, said recess 6 encloses the flange 11 and said abutment ring 10. Tightening of the clamp halves 12,13 forces thereby the transversal end faces of the abutment ring 10 and the flange 11 tightly against each other by means of the conically machined edges (25 in Figs. 3, 9). The clamp 3 provides not only longitudinal or axial restraint of the two end portions 1, 2 but also actively and positively clamps ring 10 to flange 11. Clamp 3 preferably has at least one bevelled inner edge 25 which co-operates during clamping with a chamfered edge 28 on one of the ring 10 or flange 11 (as shown in Fig. 3 the chamfered edge 28 is on the ring 10). The angle of the chamfer/bevel should be such as to provide a strong axial pressure on the respective ring 10 or flange 11. On the other one of the ring 10 or flange 11 there may be no chamfered/bevelled edges (as shown in Fig. 3) or these edges may also be provided with co-operating chamfers 29, 30 (Fig. 9). By clamping the flange 11 to the abutment ring 10 in a solid manner, relative movement between ring 10 and flange 11 is prevented, independent of whether this movement is axial with respect to end portions 1, 2 or rotational about a rotation axis parallel to the axis of end portions 1, 2 or rotational about an axis perpendicular to the axis of end portions 1, 2. This means that during rotation of the coupling, any circumferential out of balance forces do not result in repetitive small rotational or linear movements which could damage the seals 4, 5 or produce periodic movements which could cause periodic variations in the processing, e.g. when sputtering. The two ring halves 12, 13 are fixed to each other at their extremities 15,16 by a fixing means, e.g. bolts 9.

The fixing means comprises in at least one place bolting means 9, the longitudinal axis 14 of which is perpendicular to the longitudinal axis of the coupled tubular sections and substantially tangential to the clamping ring periphery. This securing of the clamp halves 12,13 together is shown here with only two bolts 9 which are screwed in threaded holes in the clamp end face 16. They can be reached and seen very easily at any rotational position of the clamp 3. This guarantees a fast and user friendly interface for mounting and removing a cylindrical tube, in particular a rotatable target. In this embodiment, as shown in Fig. 2, both bolts are fastened from the same side. This coupling system does not have to be turned through 180° about its longitudinal axis to couple and clamp the tube ends. When used for target-to-spindle couplings, the screw holes for the bolts are provided at the spindle side (towards end portion 1) to prevent or reduce the sputtering of material onto the bolts. Clamping ring 3 preferably have a solid section into which the holes for the bolts 9 are provided. The clamping ring 3 also have a recess for receiving the outer circumferential edges of the flange 11 and ring 10. This recess is preferably placed axially asymmetrically with respect to the bolts 9, i.e. to one side of the recess resulting in a smaller outer diameter for the clamp 3.

In a further embodiment shown schematically in Figs. 3 and 4 the bolts 9 are oriented in opposite directions to each other. In this manner each ring halve 12, 13 is identical and thus replaceable by the opposite one 13,12. Fig. 3 shows the use of a separate flange ring 11 at the end of the overlapping tube section 2. This feature offers the advantage that the supporting tube 7 for the target does not need to be produced each time with a flange at its end. Separate flange rings 11 can be interposed that properly fit with the design ad hoc of tube end 2 and the co-operating clamping ring 3. The flange ring 11 is fixed to the tube end 2, e.g. by welding.

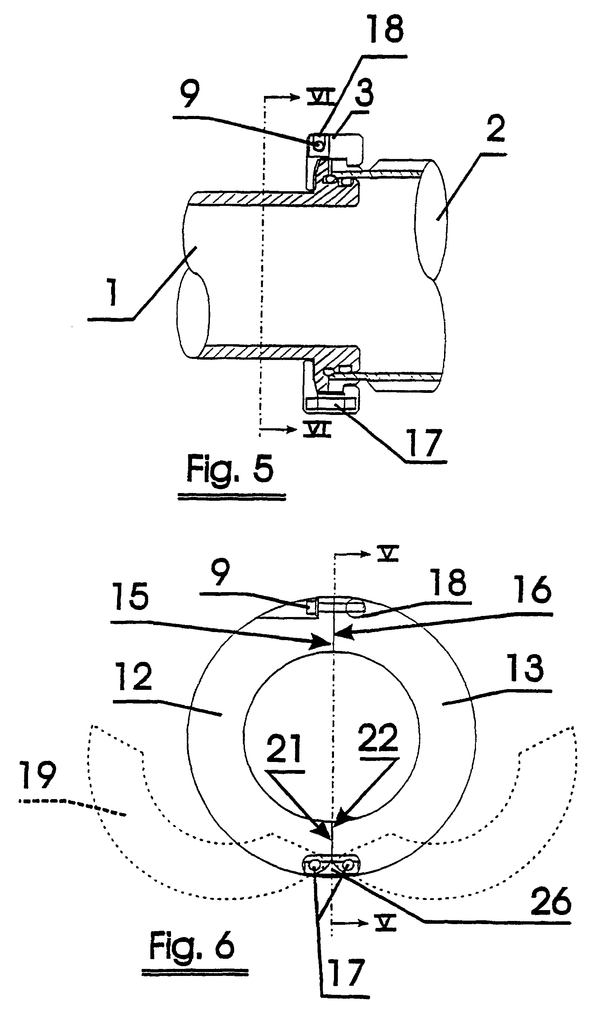

In Figs. 5 and 6 an alternative design of the clamping ring 3 is shown. The two ring halves 12 and 13 are pivotably linked to each other in one contact area of their extremities 21 and 22 by means of pivot pins 17 suitably mounted in a pivoting block 26. The two halves can be pivoted in an open position 19. The other extremities 15 and 16 are then suitably fixed to each other by a bolt 9 in an internally screw threaded bore 18.

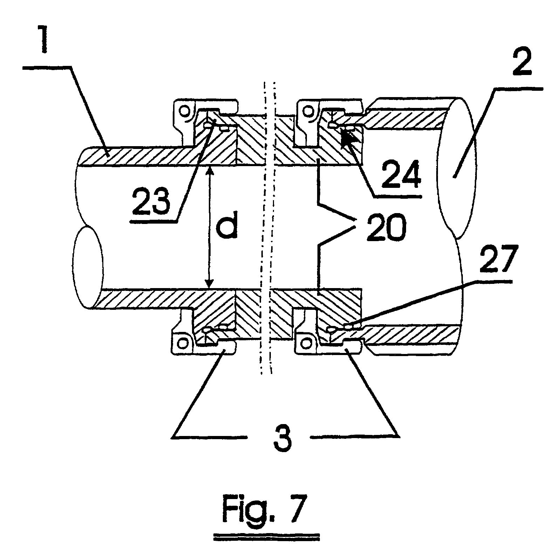

In certain vacuum chambers of sputtering reactors it is useful to provide for different sputtering widths. This corresponds to different lengths of the rotatable targets to be used. The active width of the sputtering area may thus be substantially shorter than the distance between the two opposite spindles which carry the target tubes. In this manner it is advantageous to provide at least one tubular insert section 20, as shown in Fig. 7, between spindle 1 and target tube 2. The transverse end 23 of the insert tube 20, that faces the first end portion 1 (spindle) is then again a ring which can slide axially over said first end portion. Likewise the opposite end 24 of the insert tube 20 is a ring over which said second end portion 2 can slide. This end is again provided with a suitable circumferential groove 27 for a sealing ring.

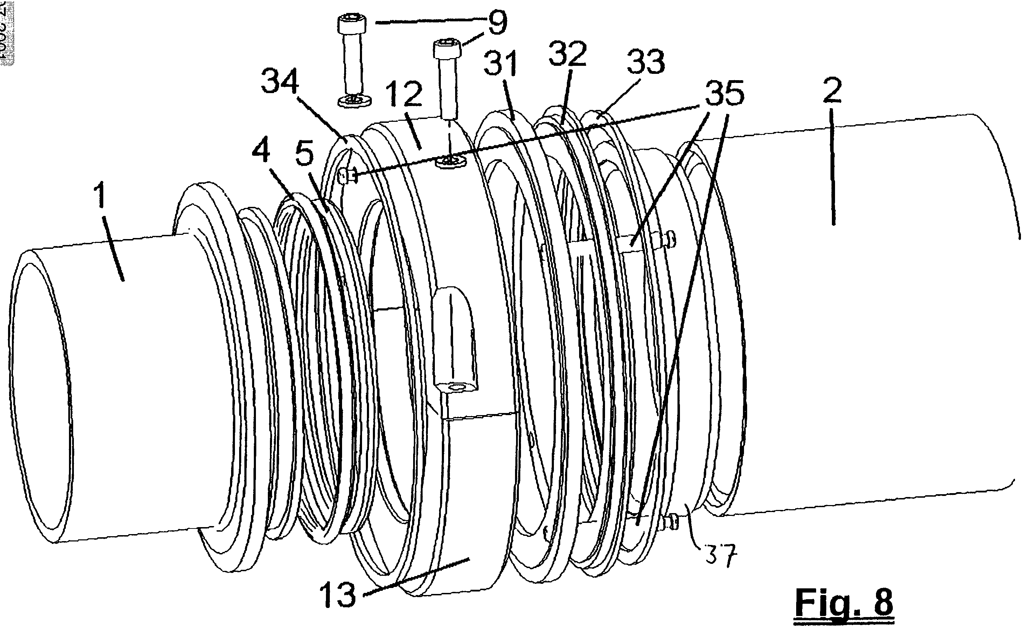

A further clamping device 3 in accordance with an embodiment of the present invention is shown schematically in Figs. 8 and 9 and can be provided with additional rings 31 and/or 32 which may be used to prevent arcing in a sputtering magnetron. One of the tube ends (2) is part of a rotating cylindrical target and can be advantageously used in a reactive sputtering process. Use of the clamping device 3 in accordance with this embodiment prevents arcing when used in a vacuum deposition process. The numbering of the various parts in Figs. 8 and 9 corresponds with those of the previous embodiments, except In previous embodiments the material to be sputtered 8 was applied onto a backing tube 7. In this embodiment the material to be deposited may be in the form of a massive tube 2 provided with an integral ring 37 fixed to the end thereof and having the appropriate clamping flange 11. Thus, in accordance with this embodiment the second end portion is 37. However, the present embodiment is not limited thereto but may include the flange fixing methods described with reference to Figs. 1 and 3.

The clamping device 3 is used as a means for mounting a cylindrical rotating target represented by 2 to a spindle represented by 1. Clamping device 3 may include two clamping semi-circular halves 12, 13 which may be fastened together with any of the fixing means described with reference to Figs. 1 to 7. The outer circumference of clamp 3 is substantially cylindrical as has been described with respect to all the previous embodiments. Clamp 3 provides positive axial clamping of the abutting flanges 10,11. For this purpose, the clamping halves 12,13 are provided with at least one bevelled surface 25, 29 which co-operates with at least one chamfered surface 28, 30 on the ring 10 and/or the flange 11 to force the ring 10 and the flange 11 together and to clamp their machined abutting surfaces positively together.

A cross-sectional view of the extended clamp in accordance with this embodiment is shown below in Fig. 9. Fig. 8 shows an exploded view. Additional rings 31 and 32 are provided which may be in two pieces, while reference numbers 33 and 34 represent retaining rings (made from a suitable material such as spring steel) for securing split rings 31 and 32 close to the clamp halves 12 and 13. Rings 33, 34 may be single pieces. Retention may be done by inserting a number of fixing pins 35 (e.g. four) through the clamp halves 12 and 13. Rings 31 and 32 provide a functional contribution during the reactive sputtering process. Retaining rings 33 and 34, together with pins 35 are intended to enable attachment of rings 31 and 32 to the clamp halves 12 and 13 which have been described in detail above. Ring 31 may be made of insulating material and is intended to isolate ring 32 electrically from the clamp halves 12,13. Ring 31 is not essential when ring 32 is insulating. During a sputtering process, clamp halves 12,13 are brought to the same potential as the target 2. Ring 32 may be made of insulating material as well. The axially directed annular lip 36 on the inner diameter of ring 32 extends over the target 2 and may have a rectangular shape in cross-section although the present invention is not limited thereto. For instance, a saw tooth-like shape, of which the edge touches the target 2 exactly at the edge of the plasma race-track induced above the target 2 in a sputtering magnetron could also be used. The present invention includes within its scope other forms of the lip 36 which extend over the target surface appropriately designed for different process conditions.

In an alternative embodiment, the ring 32 may be made from a conductive material and slightly spaced from the target surface. This ring 32 may be brought to a desired potential, grounded or be electrically floating. In this case, the presence of insulating ring 31 is advantageous to insulate the conductive ring 32 from the clamp halves 12,13 which are at a potential. Additional, in this configuration, pins 35 should be designed to prevent electrical contact of the clamp halves 12,13 with ring 32. For example, this can be achieved by using insulating pins or by putting an insulating sleeve over these pins. The lip 36 on 32, extending over the target 2, is preferably equally spaced over the target surface. The lip end, shown in Fig. 9 as having a rectangular cross-section, could have a round, saw tooth or alternative cross-section. This metallic shield may be beneficial in reducing arcing during sputtering processes. This metallic shield is not connected electrically and will assume a floating potential after plasma ignition.

Preferably, both rings 31 and 32 have a geometry at their outer circumference which provides a groove 39 between clamp halves 12, 13 and ring 31 when they are fixed together and a labyrinth groove 38 between rings 31 and 32. During a sputtering process, not only the substrate is covered with the required film, but all other bodies and walls in the vacuum chamber are coated as well. This means that eventually ring 31 and 32 will be covered with a sputtered film. If the sputtered coating is conductive, an electrical short may be formed from the clamp halves 12, 13 over the insulating ring 31 to ring 32. If ring 32 is conductive and this ring is to be maintained at a potential different from the clamp potential, it is important that no conductive path between both is formed. By providing a complex groove 38 between rings 31 and 32 and a groove 39 between clamp halves 12, 13 and ring 3, the chance of having a conductive path is reduced considerably.

The present invention also relates to a coupling for a cylindrical sputtering target comprising a coupling according to any of claims 1-7 an anti-arcing element attached to the side of the coupling facing the sputtering target. The coupling may be used to couple a cylindrical target to a spindle. The spindle may be driven to rotate the coupling and the target. The envelope of the outer surface of the coupling may be substantially circular so that the coupling may be placed within a close fitting tubular shield. Two end portions of two tubular sections may be coupled with this coupling, the size of the inner space of a first end portion being smaller than that of a second end portion, the second end portion having a flange extremity axially slidable over the first end portion to abut the flange extremity against a peripheral outer abutment ring on said first end portion, the coupling comprising at least one sealing ring between said end portions in their overlapping contact area and further comprising a clamping ring with a substantially cylindrical outer surface and being composed of two substantially equal halves, each clamp half having a semi-circular or U-shaped cross section with an inwardly oriented recess, said recess enclosing said flange extremity and said abutment ring.

## Claims

1. A vacuum tight coupling for end portions (1,2) of two tubular sections, the size of the inner space of a first end portion (1) being smaller than that of a second end portion (2), the second end portion having a flange extremity (11) axially slidable over the first end portion to abut the flange extremity 11 against a peripheral outer abutment ring (10) on said first end portion, the coupling comprising at least one sealing ring (4,5) between said end portions in their overlapping contact area and further comprising a clamping ring (3) with a substantially cylindrical outer surface and being composed of two substantially equal halves (12,13), each clamp half having a semi-circular or U-shaped cross section with an inwardly oriented recess (6), said recess enclosing said flange extremity (11) and said abutment ring (10) and being adapted to positively, solidly and axially clamp the abutment ring (10) against the flange extremity (11), the two ring halves being fixed to each other at their extremities (15,16) by means of fixing means comprising in at least one place bolting means (9), the axis (14) of which is perpendicular to the longitudinal axis of the coupled tubular sections and substantially tangential to the clamping ring periphery.

2. A coupling according to claim 1 wherein said flange extremity (11) is a separate ring.

3. A coupling according to claim 1 or 2, wherein the ring halves, besides said bolting means (9) for fixing their extremities (15,16) in one place comprise pivoting means (17) for fixing them in their opposite extremities (21,22).

4. A coupling according to any previous claim, wherein the first end portion comprises a tubular insert (20) coupled between a tubular section and the second end portion, and wherein the insert end (23) facing the tubular section is a ring which can slide axially over said tubular section whereas the opposite insert end (24) is a ring over which said second end portion (2) can slide.

5. A coupling according to any previous claim, wherein the length of the overlap portion between the first and second tube portions (1, 2) is 50% or less, preferably 30% or less, more preferably 20% or less of the inner diameter of the first portion.

6. A coupling according to any previous claim, wherein the length of the overlap portion between the first and second end portions (1, 2) is 5% or more of the inner diameter of the first portion.

7. A coupling according to any previous claim, wherein the coupling is an high vacuum or ultra-high vacuum coupling.

8. A coupling for a cylindrical sputtering target comprising the coupling according to any of claims 1 to 7.

9. The coupling for a cylindrical sputtering target according to claim 8, wherein the fixing means of the clamping ring (3) is located on the side of the coupling remote from the sputtering target.

10. The coupling for a cylindrical sputtering target according to claim 8 or 9, further comprising an anti-arcing element (32, 36) attached to a surface of the clamping ring (3) on the same side as the sputtering target for preventing arcing.

11. The coupling for a cylindrical sputtering target according to any of claims 8 to 10, wherein the anti-arcing element is conductive or insulating.

12. The coupling for a cylindrical sputtering target according to any of claims 8 to 11, wherein a at least one groove (38, 39) is provided between the anti-arcing element and the clamping ring (3).

13. The coupling according to any one of the claims 10-12, wherein the anti-arcing element touches the surface of the sputtering target.

## Patentansprüche

1. Vakuumdichte Kupplung für die Endstücke (1, 2) von zwei rohrförmigen Abschnitten, wobei:
- die Größe des inneren Raumes eines ersten Endstückes (1) kleiner als die eines zweiten Endstückes (2) ist;
- das zweite Endstück (2) ein Flanschende (11) aufweist, das axial über das erste Endstück (1) geschoben werden kann, so dass das Flanschende (11) gegen einen peripheren äußeren Anschlagring (10) an dem ersten Endstück (1) anschlägt;
- die Kupplung wenigstens einen Dichtring (4, 5) zwischen den Endstücken in ihrem überlappenden Kontaktbereich und des Weiteren einen Klemmring (3) aufweist, der eine im Wesentlichen zylindrische äußere Oberfläche aufweist und aus zwei im Wesentlichen gleichen Hälften (12, 13) besteht;
- jede Klemmenhälfte einen halbkreisförmigen oder U-förmigen Querschnitt mit einer nach innen gerichteten Vertiefung (6) aufweist;
- die Vertiefung (6) das Flanschende (11) und den Anschlagring (10) umschließt und derart ausgebildet ist, dass sie den Anschlagring (10) formschlüssig, dicht und axial gegen das Flanschende (11) klemmt; und
- die beiden Ringhälften an ihren Enden (15, 16) mit Hilfe von Befestigungsmitteln aneinander befestigt sind, die an wenigstens einer Stelle Verschraubungsmittel (9) aufweist, deren Achse (14) rechtwinklig zu der Längsachse der gekuppelten rohrförmigen Abschnitte und im Wesentlichen tangential zu der Klemmringperipherie ist.

2. Kupplung nach Anspruch 1, **dadurch gekennzeichnet, dass** das Flanschende (11) ein separater Ring ist.

3. Kupplung nach Anspruch 1 oder 2, **dadurch gekennzeichnet, dass** die Ringhälften neben den Verschraubungsmitteln (9), die dazu dienen, ihre Enden (15, 16) an einer Stelle zu befestigen, Schwenkmittel (17) aufweisen, die dazu dienen, sie an ihren gegenüberliegenden Enden (21, 22) zu befestigen.

4. Kupplung nach einem der vorhergehenden Ansprüche, **dadurch gekennzeichnet, dass** das erste Endstück (1) einen rohrförmigen Einsatz (20) aufweist, der zwischen einen rohrförmigen Abschnitt und das zweite Endstück gekoppelt ist, und dass das Einsatzende (23), das zu dem rohrförmigen Abschnitt weist, ein Ring ist, der axial über den rohrförmigen Abschnitt geschoben werden kann, wohingegen das gegenüberliegende Einsatzende (24) ein Ring ist, über den das zweite Endstück (2) geschoben werden kann.

5. Kupplung nach einem der vorhergehenden Ansprüche, **dadurch gekennzeichnet, dass** die Länge des Überlappungsabschnittes zwischen dem ersten und dem zweiten rohrförmigen Abschnitt (1, 2) 50 % oder weniger, bevorzugt 30 % oder weniger, noch bevorzugter 20 % oder weniger des inneren Durchmessers des ersten Abschnittes beträgt.

6. Kupplung nach einem der vorhergehenden Ansprüche, **dadurch gekennzeichnet, dass** die Länge des Überlappungsabschnittes zwischen dem ersten und dem zweiten Endabschnitt (1, 2) 5% oder mehr des inneren Durchmessers des ersten Abschnittes beträgt.

7. Kupplung nach einem der vorhergehenden Ansprüche, **dadurch gekennzeichnet, dass** die Kupplung eine Hochvakuum- oder eine Ultrahochvakuum-Kupplung ist.

8. Kupplung für ein zylindrisches Sputter-Ziel, die eine Kupplung nach einem der Ansprüche 1 bis 7 umfasst.

9. Kupplung für ein zylindrisches Sputter-Ziel nach Anspruch 8, **dadurch gekennzeichnet, dass** das Befestigungsmittel des Klemmringes (3) auf derjenigen Seite der Kupplung angeordnet ist, die entlegen von dem Sputterziel ist.

10. Kupplung für ein zylindrisches Sputter-Ziel nach Anspruch 8 oder 9, **dadurch gekennzeichnet, dass** sie des Weiteren ein Anti-Lichtbogenbildung-Element (32, 36) aufweist, das an einer Oberfläche des Klemmringes (3) auf derselben Seite wie das Sputter-Ziel angebracht ist und dazu dient, eine Lichtbogenbildung zu verhindern.

11. Kupplung für ein zylindrisches Sputter-Ziel nach einem der Ansprüche 8 bis 10, **dadurch gekennzeichnet, dass** das Anti-Lichtbogenbildung-Element leitfähig oder isolierend ist.

12. Kupplung für ein zylindrisches Sputter-Ziel nach einem der Ansprüche 8 bis 11, **dadurch gekennzeichnet, dass** wenigstens eine Nut (38, 39) zwischen dem Anti-Lichtbogenbildung-Element und dem Klemmring (3) vorgesehen ist.

13. Kupplung für ein zylindrisches Sputter-Ziel nach einem der Ansprüche 8 bis 12, **dadurch gekennzeichnet, dass** das Anti-Lichtbogenbildung-Element die Oberfläche des Sputter-Zieles berührt.

## Revendications

1. Dispositif de couplage étanche pour des portions terminales (1, 2) de deux sections tubulaires, la taille de l'espace intérieur d'une première portion terminale (1) étant plus petite que celle d'une seconde portion terminale (2), la seconde portion terminale ayant une extrémité de bride (11) coulissable axialement sur la première portion terminale pour rendre l'extrémité de bride (11) contiguë à un anneau extérieur périphérique de butée (10) sur ladite première portion terminale, le dispositif de couplage comprenant au moins un anneau d'étanchéité (4, 5) entre lesdites portions terminales dans leur zone de contact par recouvrement et comprenant en outre un collier de serrage (3) ayant une surface extérieure en grande partie cylindrique et étant composé de deux moitiés en grande partie égales (12, 13), chaque moitié de collier ayant une section transversale semi-circulaire ou en forme de U avec un recoin (6) orienté vers l'intérieur, ledit recoin entourant ladite extrémité de bride (11) et ledit anneau de butée (10) et étant adapté pour serrer complètement, fermement et axialement l'anneau de butée (10) contre l'extrémité de bride (11), les deux moitiés de collier étant fixées l'une à l'autre à leurs extrémités (15, 16) grâce à des moyens de fixation comprenant à au moins un endroit des moyens de verrouillage (9) dont l'axe (14) est perpendiculaire à l'axe longitudinal des sections tubulaires couplées et en grande partie tangentiel à la périphérie du collier de serrage.

2. Un dispositif de couplage selon la revendication 1, selon lequel ladite extrémité de bride (11) est un anneau séparé.

3. Un dispositif de couplage selon la revendication 1, selon lequel les moitiés de collier, en plus desdits moyens de verrouillage (9) pour fixer leurs extrémités en un endroit, comprennent des moyens de pivotement (17) pour les fixer à leurs extrémités opposées (21, 22).

4. Un dispositif de couplage selon l'une quelconque des revendications précédentes, selon lequel la première portion terminale comprend une pièce insérée tubulaire (20) couplée entre une section tubulaire et la seconde portion terminale, et selon lequel l'extrémité (23) de la pièce insérée faisant face à la section tubulaire est un anneau qui peut coulisser axialement sur ladite section tubulaire tandis que l'extrémité opposée (24) de la pièce insérée est un anneau sue lequel ladite seconde portion terminale (2) peut coulisser.

5. Un dispositif de couplage selon l'une quelconque des revendications précédentes, selon lequel la longueur de la zone de recouvrement entre les première et seconde portions tubulaires (1, 2) est de 50% ou moins, de préférence 30% ou moins, plus préférentiellement 20% ou moins du diamètre interne de la première portion.

6. Un dispositif de couplage selon l'une quelconque des revendications précédentes, selon lequel la longueur de la zone de recouvrement entre les première et seconde portions terminales (1, 2) est de 5% ou moins du diamètre interne de la première portion.

7. Un dispositif de couplage selon l'une quelconque des revendications précédentes, selon lequel le dispositif de couplage est un dispositif de couplage sous haut vide ou très haut vide.

8. Un dispositif de couplage pour cible cylindrique de vaporisation sous vide, comprenant le dispositif de couplage selon l'une quelconque des revendications 1 à 7.

9. Le dispositif de couplage pour cible cylindrique de vaporisation sous vide selon la revendication 8, selon lequel les moyens de fixation du collier de serrage (3) sont situés sur le côté du dispositif de couplage, à distance de la cible de vaporisation sous vide.

10. Le dispositif de couplage pour cible cylindrique de vaporisation sous vide selon la revendication 8 ou 9, comprenant en outre un élément évitant la formation d'un arc (32, 36) attaché à une surface du collier de serrage (3) du même côté que la cible de vaporisation sous vide pour éviter la formation d'un arc.

11. Le dispositif de couplage pour cible cylindrique de vaporisation sous vide selon l'une quelconque des revendications 8 à 10, selon lequel l'élément évitant la formation d'un arc est conducteur ou isolant.

12. Le dispositif de couplage pour cible cylindrique de vaporisation sous vide selon l'une quelconque des revendications 8 à 11, selon lequel au moins une cannelure (38, 39) est prévue entre l'élément évitant la formation d'un arc et le collier de serrage (3).

13. Le dispositif de couplage selon l'une quelconque des revendications 10 à 12, selon lequel l'élément évitant la formation d'un arc touche la surface de la cible de vaporisation sous vide.
